# EUROPÄISCHE PATENTANMELDUNG

(11) **EP 3 034 531 A1**
(43) Veröffentlichungstag der Anmeldung: **22.06.2016**
(21) Anmeldenummer: 14199296.6
(22) Anmeldetag: 19.12.2014
(51) Int. Cl.: C08F 255/02, C09D 123/04, H01L 31/00

(54) **Dispersion zum einfachen Einsatz in der Herstellung von Verkapselungsfolien**

(71) Anmelder: Evonik Degussa GmbH, 45128 Essen (DE)
(72) Erfinder: Ulbricht, Dr. Daniel,, 64295 Darmstadt (DE); Hein, Marcel, 63843 Niedernberg (DE); Kleff, Frank, 63486 Bruchköbel-Oberissigheim (DE); Schauhoff, Dr. Stephanie, 63225 Langen (DE); Ohlemacher, Jürgen, 61118 Bad Vilbel (DE)

(57) **Zusammenfassung**

Die vorliegende Erfindung betrifft eine Dispersion **(D)** umfassend (i) mindestens ein Polyolefincopolymer **(I)** als kontinuierliche Phase; und (ii) mindestens eine in dem Polyolefincopolymer **(I)** dispergierte (Meth)acrylamidverbindung. Daneben betrifft die vorliegende Erfindung die Verwendung der Dispersion **(D)** zur Herstellung einer Folie zur Verkapselung einer elektronischen Vorrichtung, insbesondere einer Solarzelle. Weiterhin betrifft die Erfindung ein Verfahren zur Herstellung der Dispersion **(D).** Die Erfindung betrifft schließlich auch die mit Hilfe dieses Verfahrens erhaltene Dispersion **(D).**

## Beschreibung

Die vorliegende Erfindung betrifft eine Dispersion **(D)** umfassend (i) mindestens ein Polyolefincopolymer **(I)** als kontinuierliche Phase; und (ii) mindestens eine in dem Polyolefincopolymer **(I)** dispergierte (Meth)acrylamidverbindung. Daneben betrifft die vorliegende Erfindung die Verwendung der Dispersion **(D)** zur Herstellung einer Folie zur Verkapselung einer elektronischen Vorrichtung, insbesondere einer Solarzelle. Weiterhin betrifft die Erfindung ein Verfahren zur Herstellung der Dispersion **(D).** Die Erfindung betrifft schließlich auch die mit Hilfe dieses Verfahrens erhaltene Dispersion **(D).**

### Hintergrund der Erfindung

Photovoltaikmodule (Photovoltaik = "PV") bestehen üblicherweise aus einer Lage symmetrisch angeordneter Siliziumzellen, welche in zwei Lagen einer Schutzfolie eingeschweißt werden. Diese Schutzfolie ist selbst wiederum durch ein *"backsheet"* auf ihrer Rück- und ein *"frontsheet"* auf ihrer Vorderseite stabilisiert. *"Backsheet"* und *"frontsheet"* können sowohl geeignete Kunststofffolien sein als auch aus Glas bestehen. Die Funktion des Verkapselungsmaterials besteht im Wesentlichen darin, das PV-Modul vor Witterungseinflüssen und mechanischer Belastung zu schützen, weshalb die mechanische Stabilität des jeweiligen Verkapselungsmaterials eine wichtige Eigenschaft darstellt. Daneben weisen gute Verkapselungsmaterialien eine schnelle Aushärtungsgeschwindigkeit, einen hohen Gelgehalt, eine hohe Transmission, eine geringe Neigung zu temperatur- und wärmeinduzierter Verfärbung sowie eine hohe Adhäsion (also eine geringe Neigung zur UV-induzierten Delaminierung) auf.

Die im Stand der Technik (zum Beispiel WO 2008/036708 A2) zu diesem Zweck beschriebenen Verkapselungsmaterialien beruhen typischerweise auf Materialien wie Silikonharzen, Polyvinylbutyralharzen, Ionomeren, Polyolefinfolien oder Ethylen-Vinylacetat-Copolymeren ("EVA").

Verfahren zur Herstellung solcher Verkapselungsfolien sind dem Fachmann geläufig. In diesen Verfahren werden die Vernetzer zusammen mit einem Polyolefin-Copolymer (und eventuell weiteren Additiven) z. B. in einem Extruder homogen vermischt und dann zu einer Folie extrudiert. EVA-Verkapselungsfolien beschreibt zum Beispiel die EP 1 164 167 A1. Das dort beschriebende Verfahren ist aber auch auf Folien aus anderen, zum Beispiel den vorgenannten, Materialien anwendbar.

Die Verkapselung der Siliziumzellen erfolgt typischerweise in einem Vakuumlaminierofen (EP 2 457 728 A1). Dazu wird der Schichtaufbau des PV-Moduls vorbereitet und in einem Laminierofen (bestehend aus zwei durch eine Membran getrennten Kammern) zunächst langsam aufgeheizt. Dadurch erweicht das Polyolefin-Copolymer (zum Beispiel EVA). Gleichzeitig wird der Ofen evakuiert, um die Luft zwischen den Schichten zu entfernen. Dieser Schritt ist der kritischste und dauert zwischen 4 bis 6 Minuten. Im Anschluss daran wird das Vakuum über die zweite Kammer gebrochen, und über Anlegen eines Drucks werden die Schichten des Moduls miteinander verschweißt. Gleichzeitig wird bis zur Vernetzungstemperatur weiter aufgeheizt, wobei in diesem letzten Schritt dann die Vernetzung der Folie stattfindet.

Gerade EVA wird standardmäßig bei der Herstellung von Verkapselungsfolien für Solarmodule eingesetzt. Allerdings weist es auch einen geringeren spezifischen elektrischen Durchgangswiderstand p als diese auf. Dies macht den Einsatz von EVA-Folien als Verkapselungsmaterial unattraktiver, da gerade Verkapselungsmaterialien mit hohem spezifischem elektrischem Durchgangswiderstand p gewünscht sind.

Bei PV-Modulen stellt nämlich der sogenannte "PID"-Effekt (PID *= "potential induced degradation")* derzeit ein großes Qualitätsproblem dar. Unter dem Begriff PID versteht man eine spannungsbedingte Leistungsdegradation, hervorgerufen durch sogenannte "Leckströme" innerhalb des PV-Moduls.

Ursache für die schädlichen Leckströme ist neben dem Aufbau der Solarzelle die Spannungslage der einzelnen PV-Module gegenüber dem Erdpotential - bei den meisten ungeerdeten PV-Systemen sind die PV-Module einer positiven oder negativen Spannung ausgesetzt. PID tritt meistens bei einer negativen Spannung gegenüber Erdpotential auf und wird durch hohe Systemspannungen, hohe Temperaturen und hohe Luftfeuchtigkeit beschleunigt. In der Folge wandern Natriumionen aus dem Deckglas des PV-Moduls an die Grenzfläche der Solarzelle und verursachen dort Schäden *("shunt"),* die zu Leistungsverlusten und sogar zum Totalverlust des PV-Moduls führen können.

Das Risiko des Eintretens eines PID-Effektes kann durch die Erhöhung des spezifischen elektrischen Durchgangswiderstands p der Verkapselungsfolien deutlich reduziert werden.

Der spezifische elektrische Durchgangswiderstand p oder auch Resistivität *("volume resistivity",* im Folgenden auch abgekürzt als "*VR*") ist eine temperaturabhängige Materialkonstante. Er wird zur Berechnung des elektrischen Widerstands eines homogenen elektrischen Leiters genutzt. Der spezifische elektrische Durchgangswiderstand wird erfindungsgemäß mittels ASTM-D257 bestimmt.

Je höher der spezifische elektrische Durchgangswiderstand p eines Materials ist, desto geringer ist die Anfälligkeit von Photovoltaikmodulen gegenüber dem PID-Effekt. Eine wesentliche, positive Auswirkung bei der Steigerung des spezifischen elektrischen Durchgangswiderstands p von Verkapselungsfolien ist daher die Erhöhung der Lebensdauer und Effizienz von PV-Modulen.

Im Stand der Technik wird das Problem des PID-Effekts im Zusammenhang mit Verkapselungsfolien für PV-Module in der CN 103525321 A diskutiert. Diese Schrift beschreibt eine EVA-basierte Folie zur Verkapselung von Solarzellen, welche als Co-Vernetzer Triallylisocyanurat ("TAIC") und Trimethylolpropantrimethacrylat ("TMPTMA") sowie als weitere Additive bevorzugt ein Polyolefinionomer und ein Polysiloxan zur Hydrophobisierung enthält. Diese Folie weist einen verminderten PID-Effekt auf. Nachteilig an ihr ist allerdings, dass Polyolefinionomere relativ teuer sind. Außerdem wirken sich Polysiloxane negativ auf die Haftungseigenschaften aus. Zudem werden in den Beispielen keine spezifischen Angaben darüber gemacht, mit welchen Konzentrationen welche Verbesserungen erreicht werden können.

Eine Vernetzerkombination aus TAIC und TMPTMA beschreibt auch die JP 2007-281135 A. Das TMPTMA bewirkt hierbei eine Beschleunigung der Vernetzungsreaktion und führt damit zu einer erhöhten Produktivität.

Die JP 2012-067174 A und die JP 2012-087260 A beschreiben eine auf EVA bzw. einem Polyolefin basierende Verkapselungsfolie für Solarzellen, die neben TAIC zum Beispiel Ethylenglykoldimethacrylat, Neopentylglykoldimethacrylat, 1,6-Hexandioldimethacrylat als Vernetzer aufweist. Diese Co-Crosslinker verlangsamen die Vernetzungsreaktion am Anfang etwas und erhöhen dadurch das Verarbeitungszeitfenster.

Die JP 2009-135200 A beschreibt ebenfalls Vernetzer umfassend TAIC und verschiedene (Meth)acrylatderivate polyfunktioneller Alkohole, wobei in diesem Fall eine verbesserte Hitzebeständigkeit verbunden mit einer geringeren Tendenz zur Delamination der EVA-basierten Verkapselung beschrieben wird.

Die JP 2007-281135 A und die JP 2007-305634 A beschreiben Vernetzerkombinationen aus TAIC und Trimethylolpropantriacrylat ("TMPTA") zur Verwendung bei der Herstellung von mehrschichtigen co-extrudierten EVA-Verkapselungsfolien für Solarzellen.

Ähnliche Kombinationen von Vernetzern für Solarzellenverkapselungsfolien beschreiben z. B. die JP 2013-138094 A, JPH11-20094, JPH11-20095, JPH11-20096, JPH11-20097, JPH11-20098, JPH11-21541, CN 102391568 A, CN 102504715 A, CN 102863918 A, CN 102911612 A, CN 103045105 A, CN 103755876 A, CN 103804774 A, US 2011/0160383 A1, WO 2014/129573 A1.

Ein weitere Gruppe von Vernetzern ist im anderen Zusammenhang (Behandlung von Druckplatten) im Stand der Technik beschrieben (EP 0 228 638 A1, DE 37 04 067 A1). Es handelt sich dabei um Vernetzer der nachfolgend definierten chemischen Struktur **(II),** insbesondere Methylenbisacrylamid.

Diese Verbindungsklasse bringt jedoch, wenn man sie bei der im Stand der Technik beschriebenen Verwendung zur Herstellung von Verkapselungsfolien für Solarzellen einsetzen will, Nachteile mit sich, die sie für diesen Zweck unattraktiv macht.

Herkömmlich erfolgt die Herstellung der Polyolefincopolymerfolie (im Folgenden anhand der EVA-Folie erklärt, aber auch auf andere Polyolefincopolymerfolien übertragbar) nämlich so, dass EVA vorgelegt wird und der Vernetzer oder eine Mischung des jeweiligen Vernetzers mit weiteren Additiven wie Peroxiden oder Co-Vernetzern auf das EVA aufgesprüht wird. Die aufgesprühte Lösung lässt man dann eindiffundieren, wonach die Folie extrudiert werden kann. Dieses Verfahren scheidet jedoch im Falle von Vernetzern der nachfolgend definierten chemischen Struktur **(II),** insbesondere Methylenbisacrylamid, von vornherein aus, da diese nicht flüssig sind.

Zwar besteht gemäß Stand der Technik bei nicht flüssigen Vernetzern die Möglichkeit, diese in einem geeigneten Lösungsmittel zu lösen und dann erst zusammen mit eventuell weiteren Additiven auf das EVA aufzusprühen. Diese Vorgehensweise bringt jedoch auch Nachteile mit sich, denn das Lösungsmittel muss vor oder während der Extrusion wieder entfernt werden, was zusätzlichen Aufwand und Investitionen bedeutet und gerade bei großtechnischen Anwendungen zu hohen Kosten führt. Außerdem sind viele der in Frage kommenden Lösungsmittel, z. B. Methanol, giftig und entflammbar, was zusätzliche Vorkehrungen hinsichtlich Arbeits- und Explosionsschutz erfordert.

Ein direktes Aufbringen des pulverförmigen Vernetzers zusammen mit den flüssigen Additiven auf das EVA-Granulat scheidet aufgrund der mangelnden Adhäsion des Vernetzers auf dem Granulat aus. Zwar wird das Pulver zunächst durch die flüssigen Additive gleichmäßig auf der Oberfläche des Polymergranulats verteilt und haftet zunächst an der feuchten Oberfläche. Sobald jedoch die flüssigen Additive vollständig in das Polymer eindiffundiert sind, haftet der Feststoff nicht mehr auf der Oberfläche und wird durch die Bewegung des Granulats wieder abgerieben, so dass eine Entmischung auftritt und keine homogene Verteilung möglich ist. Die mit einer solchen Mischung erhaltene Folie weist zu große Inhomogenitäten auf, was hinsichtlich der Verkapselungsfolien für Solarzellen zu nicht akzeptablen Schwankungen des VR-Wertes führt.

Eine weitere Möglichkeit, den pulverförmigen Vernetzer in die Polymerformulierung einzubringen, ist die direkte separate gravimetrische Dosierung des Pulvers in den Extruder bei der Folienherstellung. Dabei besteht jedoch das Problem, dass nur sehr kleine Konzentrationen des Vernetzers, bezogen auf das Polyolefincopolymer, benötigt werden, so dass eine genaue Dosierung technisch schwer realisierbar ist.

Die Aufgabe der vorliegenden Erfindung bestand demnach darin, eine Zusammensetzung zur Verfügung zu stellen, welche es ermöglicht, die Vernetzer der nachfolgenden chemischen Struktur **(II),** insbesondere Methylenbisacrylamid, bei der Herstellung einer Polyolefincopolymerfolie (insbesondere EVA-Folie) verwenden zu können, wobei die so erhaltene Folie einen so hohen VR-Wert aufweisen sollte, dass sie zur Verkapselung von Solarzellen verwendet werden kann. Außerdem sollte ein Verfahren zur Herstellung solcher Folien zur Verfügung gestellt werden.

Es wurde nun überraschend gefunden, dass die erfindungsgemäße Aufgabe durch die nachfolgend definierten Dispersionen gelöst wird.

### Detaillierte Beschreibung der Erfindung

Die Dispersionen gemäß der vorliegenden Erfindung können überraschend zur Herstellung von Folien zur Verkapselung von elektronischen Vorrichtungen wie zum Beispiel Solarzellen mit einem spezifischen Durchgangswiderstand, der über die gesamte Folie einen hohen Wert aufweist, verwendet werden.

Die erfindungsgemäße Dispersion **(D)** umfasst demnach
(i) mindestens ein Polyolefincopolymer **(I)** als kontinuierliche Phase; und
(ii) mindestens eine in dem Polyolefincopolymer **(I)** dispergierte Verbindung der chemischen Struktur **(II)** mit 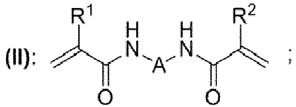
Wobei
R¹, R² unabhängig voneinander jeweils Wasserstoff oder Methyl ist;
A ausgewählt ist aus der Gruppe bestehend aus
unverzweigte oder verzweigte Alkylengruppe mit 1 bis 20 Kohlenstoffatomen, bei welcher mindestens ein Wasserstoffrest durch einen Halogenrest substituiert sein kann und bei welcher ein oder zwei Wasserstoffreste durch jeweils einen Rest ausgewählt aus der Gruppe bestehend aus -OR³, -C(=O)NR⁴R⁵ substituiert sein können,
Arylengruppe mit 6 bis 14 Kohlenstoffatomen, bei welcher mindestens ein Wasserstoffrest durch einen Halogenrest oder einen Alkylrest mit 1 bis 10 Kohlenstoffatomen substituiert sein kann und bei welcher ein oder zwei Wasserstoffreste durch jeweils einen Rest ausgewählt aus der Gruppe bestehend aus -OR⁶, -C(=O)NR⁷R⁸ substituiert sein können,
ein verbrückender Rest der chemischen Struktur -A¹-X-A²-;
wobei R³, R⁴, R⁵, R⁶, R⁷, R⁸ unabhängig voneinander jeweils ausgewählt aus der Gruppe bestehend aus Wasserstoff, verzweigter oder unverzweigter Alkylrest mit 1 bis 10 Kohlenstoffatome sind;
wobei A¹, A² unabhängig voneinander jeweils eine verzweigte oder unverzweigte Alkylengruppe mit 1 bis 10 Kohlenstoffatomen ist;
und wobei X ausgewählt aus der Gruppe bestehend aus -O-, -S-S-, -S-, -NR⁹- mit R⁹ = Alkylrest mit 1 bis 10 Kohlenstoffatomen ist.

Eine Verbindung der chemischen Struktur **(II)** wird im Sinne der Erfindung auch als "(Meth)acrylamidverbindung" bezeichnet.

Insbesondere ist in der chemischen Struktur **(II)**
R¹, R² unabhängig voneinander jeweils Wasserstoff oder Methyl;
A ausgewählt aus der Gruppe bestehend aus
unverzweigte oder verzweigte Alkylengruppe mit 1 bis 20 Kohlenstoffatomen, Arylengruppe mit 6 bis 14 Kohlenstoffatomen, ein verbrückender Rest der chemischen Struktur -A¹-X-A²-;
wobei A¹, A² unabhängig voneinander jeweils eine verzweigte oder unverzweigte Alkylengruppe mit 1 bis 10 Kohlenstoffatomen ist;
und wobei X ausgewählt aus der Gruppe bestehend aus -O-, -S-S-, -S-, -NR⁹- mit R⁹ = unverzweigter oder verzweigter Alkylrest mit 1 bis 10 Kohlenstoffatomen ist.

In einer bevorzugten Ausführungsform der Dispersion **(D)** ist in der chemischen Struktur **(II)** R¹, R² unabhängig voneinander jeweils Wasserstoff oder Methyl; A ist ausgewählt aus der Gruppe bestehend aus unverzweigte oder verzweigte Alkylengruppe mit 1 bis 20 Kohlenstoffatomen, Arylengruppe mit 6 bis 14 Kohlenstoffatomen, ein verbrückender Reste der chemischen Struktur -A¹-O-A²-, wobei A¹, A² unabhängig voneinander jeweils eine verzweigte oder unverzweigte Alkylengruppe mit 1 bis 10 Kohlenstoffatomen ist.

In einer bevorzugteren Ausführungsform der Dispersion **(D)** ist in der chemischen Struktur **(II)** R¹, R² unabhängig voneinander jeweils Wasserstoff oder Methyl, insbesondere beide jeweils Wasserstoff oder beide jeweils Methyl; A ist ausgewählt aus der Gruppe bestehend aus unverzweigte oder verzweigte Alkylengruppe mit 1 bis 12 Kohlenstoffatomen, Phenylen, -(CH₂)₂-O-(CH₂)₂-, -CH₂-O-CH₂-.

In einer noch bevorzugteren Ausführungsform der Dispersion **(D)** ist in der chemischen Struktur **(II)** R¹ = R² = Wasserstoff oder R¹ = R² = Methyl; A ist ausgewählt aus der Gruppe bestehend aus unverzweigte oder verzweigte Alkylengruppe mit 1 bis 12, insbesondere 1 bis 10, bevorzugt 1 bis 8, bevorzugter 1 bis 6 Kohlenstoffatomen, -(CH₂)₂-O-(CH₂)₂-, -CH₂-O-CH₂-. Solche Verbindungen der chemischen Struktur **(II)** sind zum Beispiel *N,N'-*Methylendiacrylamid, *N*,*N*'-Methylendimethacrylamid, *N*,*N*'-Ethylendiacrylamid, *N*,*N*'-Hexamethylendiacrylamid, Bisacrylamiddimethylether.

In einer noch besonders bevorzugteren Ausführungsform der Dispersion **(D)** ist in der chemischen Struktur **(II)** R¹ = R² = Wasserstoff; A ist ausgewählt aus der Gruppe bestehend aus unverzweigte oder verzweigte Alkylengruppe mit 1 bis 12, insbesondere 1 bis 10, bevorzugt 1 bis 8, bevorzugter 1 bis 6 Kohlenstoffatomen, -(CH₂)₂-O-(CH₂)₂-,-CH₂-O-CH₂-.

Solche Verbindungen der chemischen Struktur **(II)** sind zum Beispiel *N*,*N*'-Methylendiacrylamid, *N*,*N*'-Ethylendiacrylamid, *N*,*N*'-Hexamethylendiacrylamid, Bisacrylamiddimethylether.

*N*,*N*'-Methylendiacrylamid ist eine Verbindung der Struktur **(II)** mit R¹ = R² = H und A = -CH₂-.

*N*,*N*'-Methylendimethacrylamid ist eine Verbindung der Struktur **(II)** mit R¹ = R² = CH₃ und A = -CH₂-.

*N*,*N*'-Ethylendiacrylamid ist eine Verbindung der Struktur **(II)** mit R¹ = R² = H und A = -CH₂-CH₂-.

*N*,*N*'-Hexamethylendiacrylamid ist eine Verbindung der Struktur **(II)** mit R¹ = R² = H und A = -(CH₂)₆-.

Bisacrylamiddimethylether ist eine Verbindung der Struktur **(II)** mit R¹ = R² = H und A = -CH₂-O-CH₂-.

Eine "Alkylengruppe" ist im Sinne der Erfindung ein zweiwertiger gesättigter Kohlenwasserstoffrest.

Eine "Arylengruppe" ist im Sinne der Erfindung ein zweiwertiger aromatischer Kohlenwasserstoffrest, zum Beispiel Naphthalen, Phenanthren, Phenylen.

"Phenylen" umfasst im Sinne der Erfindung 1,2-Phenylen, 1,3-Phenylen, 1,4-Phenylen.

Eine unverzweigte oder verzweigte Alkylengruppe mit 1 bis 6 Kohlenstoffatomen ist insbesondere ausgewählt aus Methylen, Ethylen, n-Propylen, n-Butylen, n-Pentylen, n-Hexylen. "*n*-Hexylen" ist gleichbedeutend mit "Hexamethylen".

"Dispersion" bedeutet gemäß Fachwissen und im Sinne der Erfindung eine Zusammensetzung umfassend unlösliche Feststoffteilchen (im Folgenden werden "unlösliche Feststoffteilchen" auch "Partikel" genannt) in einer kontinuierlichen Phase, die fest oder flüssig sein kann, bevorzugt aber fest ist.

In der erfindungsgemäßen Dispersion **(D)** ist das Polyolefincopolymer **(I)** die kontinuierliche Phase, die fest oder flüssig sein kann, bevorzugt aber fest ist, und die Verbindung der chemischen Struktur **(II)** die dispergierte Phase.

Die Dispersion **(D)** eignet sich insbesondere als Masterbatch bei der lösungsmittelfreien Herstellung von EVA-Folien mit durchgehend hohem spezifischem Widerstand und ist deshalb insbesondere für großtechnische Anwendungen hervorragend geeignet. Es wurde völlig überraschend festgestellt, dass mit den erfindungsgemäßen Dispersionen **(D)** eine Herstellung von EVA-Folien insbesondere ohne Einsatz zusätzlicher Lösungsmittel möglich ist und insbesondere Folien hergestellt werden können, die einen höheren Minimal-VR-Wert aufweisen als Folien, die mit herkömmlichen, auf die Verwendung von Lösungsmitteln angewiesenen Verfahren hergestellt wurden.

Der Anteil an allen Verbindungen der chemischen Struktur **(II)** bezogen auf das Gesamtgewicht aller von der Dispersion **(D)** umfassten Polyolefincopolymere **(I)** in der Dispersion **(D)** ist nicht besonders beschränkt. Bevorzugt liegt jedoch der Anteil an allen Verbindungen der chemischen Struktur **(II)** bezogen auf das Gesamtgewicht aller von der Dispersion **(D)** umfassten Polyolefincopolymere **(I)** im Bereich 0.1 bis 25.0 Gew.-%, bevorzugter bei 1.0 bis 11.1 Gew.-%, noch bevorzugter bei 2.0 bis 10.0 Gew.-%, noch mehr bevorzugter bei 3.0 bis 9.0 Gew.-%, am bevorzugtesten bei 5.3 bis 8.1 Gew.-%.

Erfindungsgemäß einsetzbare Polyolefincopolymere (I) sind dem Fachmann bekannt und etwa in der WO 2008/036708 A2 und der JP 2012-087260 beschrieben.

Insbesondere werden erfindungsgemäß als Polyolefincopolymere **(I)** Ethylen/ α-Olefin-Interpolymere eingesetzt, wobei der Begriff "Interpolymer" bedeutet, dass das betreffende Polyolefincopolymer aus mindestens zwei verschiedenen Monomeren hergestellt wurde. Somit schließt der Begriff "Interpolymer" insbesondere Polyolefincopolymere aus genau zwei Monomereinheiten, aber auch Terpolymere (zum Beispiel Ethylen/Propylen/1-Octen, Ethylen/Propylen/Buten, Ethylen/Buten/1-Octen, Ethylen/Buten/Styrol) und Tetrapolymere ein.

Als Polyolefincopolymere kommen erfindungsgemäß insbesondere Ethylen/ α-Olefin-Copolymere, die bevorzugt neben Ethylen und dem α-Olefin keine weiteren Monomereinheiten aufweisen, in Frage, wobei im Sinne der Erfindung das "α-Olefin" bevorzugt ausgewählt ist aus der Gruppe bestehend aus Propen, 1-Buten, 4-Methyl-1-Penten, 1-Hexen, 1-Octen, 1-Decen, 1-Dodecen, 1-Tetradecen, 1-Hexadecen, 1-Octadecen, 3-Cyclohexyl-1-propen, Vinylcyclohexan, Acrylsäure, Methacrylsäure, Norbornen, Styrol, Methylstyrol, Vinylacetat.

Noch bevorzugter ist das erfindungsgemäße Polyolefincopolymer in der Dispersion (D) ein Ethylen-Vinylacetat-Copolymer.

Werden als Polyolefincopolymere Ethylen/ α-Olefin-Interpolymere eingesetzt, so weisen diese insbesondere einen α-Olefin-Gehalt im Bereich 15 bis 50 Gew.-%, bezogen auf das Gesamtgewicht des Ethylen/ α-Olefin-Interpolymers, auf. Bevorzugt liegt der α-Olefin-Gehalt im Bereich 20 bis 45 Gew.-%, bevorzugter im Bereich 25 bis 40 Gew.-%, noch bevorzugter 26 bis 34 Gew.-%, am bevorzugtesten 28 bis 33 Gew.-%, jeweils bezogen auf das Gesamtgewicht des Ethylen/ α-Olefin-Interpolymers.

In der bevorzugten Ausführungsform, in welcher es sich bei dem Polyolefincopolymer um ein Ethylen-Vinylacetat-Copolymer handelt, weist das Ethylen-Vinylacetat-Copolymer insbesondere einen Vinylacetat-Gehalt im Bereich 15 bis 50 Gew.-%, bezogen auf das Gesamtgewicht des Ethylen-Vinylacetat-Copolymers, auf. Bevorzugt liegt der Vinylacetat-Gehalt dann im Bereich 20 bis 45 Gew.-%, bevorzugter im Bereich 25 bis 40 Gew.-%, noch bevorzugter 26 bis 34 Gew.-%, am bevorzugtesten 28 bis 33 Gew.-% jeweils bezogen auf das Gesamtgewicht des Ethylen-Vinylacetat-Copolymers.

Der α-Olefin-Gehalt, insbesondere im Falle des Ethylen/ Vinylacetat-Copolymer der Gehalt an Vinylacetat, wird dabei mit dem in ASTM D 5594:1998 ["*Bestimmung des Vinylacetatgehalts von Ethylenvinylacetat(EVA)-Copolymeren mit Hilfe der Fourier-Transformations-Infrarotspektroskopie*"] beschriebenen Verfahren bestimmt.

Insbesondere liegt in der Dispersion **(D)** die Verbindung der chemischen Struktur **(II)** in Partikeln in der vom Polyolefincopolymer **(I)** gebildeten kontinuierlichen Phase vor. Um einen möglichst hohen VR-Wert der Polymerfolie zu erreichen ist es von Vorteil, wenn die Verbindung der chemischen Struktur **(II)** möglichst fein verteilt in dem Polyolefincopolymer (I) vorliegt. Insbesondere liegt deshalb die dispergierte Verbindung der chemischen Struktur **(II)** in Partikeln vor, wobei mindestens 50 % aller von der Dispersion **(D)** umfassten Partikel der chemischen Struktur **(II)** eine Partikelgröße von ≤ 100 µm bevorzugt von ≤ 75 µm, noch bevorzugter ≤ 50 µm. Dabei haben insbesondere mindestens 50 % aller von der Dispersion **(D)** umfassten Partikel der chemischen Struktur **(II)** eine Partikelgröße im Bereich 1 µm bis 100 µm, bevorzugt 1 µm bis 75 µm, bevorzugter 1 µm bis 50 µm. Am bevorzugtesten haben 95 % der Partikel eine Partikelgröße von ≤ 25 µm, insbesondere haben 95% der Partikel eine Partikelgröße im Bereich 1 µm bis 25 µm.

Es ist außerdem von Vorteil, wenn die Partikel eine gewisse Maximalgröße nicht überschreiten, um mögliche Inhomogenitäten der mit Dispersion **(D)** hergestellten Folie zu minimieren.

In einer weiteren noch bevorzugteren Ausführungsform der Dispersion **(D)** liegt die dispergierte Verbindung der chemischen Struktur **(II)** in Partikeln vor, wobei alle Partikel eine Partikelgröße von ≤ 1 mm aufweisen.

Als "Partikelgröße" ist erfindungsgemäß der Durchmesser einer kleinstmöglichen Kugel definiert, die sich um das jeweilige Partikel unabhängig von seiner Form ziehen lässt und dabei gleichzeitig das Partikel vollständig umfasst.

Die Partikelgröße wird erfindungsgemäß mit Hilfe der Lichtmikroskopie bestimmt. Hierbei wird Polymergranulat der erfindungsgemäßen Mischung zu einer Folie mit einer Dicke von maximal 0.5 mm verpresst und mit einem Lichtmikroskop (Zeiss Axioscope M2m) untersucht.

Das Granulat wird zunächst auf eine Temperatur oberhalb des Schmelzpunktes des Polyolefincopolymers (im Fall von EVA zum Beispiel 120°C) erwärmt. Das anschließende Verpressen der heißen Polymerschmelze erfolgt schonend, so dass bei einem leichten Anpressdruck < 500 g / cm² das Polymer verfließt, ohne dabei die Partikel zu schädigen. Danach werden zunächst mit einer Übersichtsvergrößerung (Abbildung mit 10-fach Objektiv und einem Bildausschnitt von 1420 µm) acht Bilder hinsichtlich der Partikelgrößenverteilung untersucht. Kleine Partikel werden mit der Detailvergrößerung (Abbildung mit 100-fach Objektiv und einem Bildausschnitt von 142 µm) erfasst, wobei auch in diesem Fall acht Bilder untersucht werden. Die Auswertung erfolgt mit der Bildverarbeitungssoftware Image Pro Plus (Firma Media Cybernetics), mit der das Bild automatisch ausgewertet wird, d. h. Anzahl und Größe der Partikel bestimmt werden. Weiterhin kann mit Hilfe der Software der prozentuale Anzahl der Partikel < 100 µm angezeigt werden. Um eine repräsentative Aussage über die Partikelgrößenverteilung sicherzustellen, werden die unterschiedlichen Folienausschnitte ausgewertet und hieraus ein Mittelwert errechnet. Alle Bilder werden in unterschiedlichen Bereichen der Probe aufgenommen, um Mehrfacherfassung einzelner Partikel zu vermeiden.

Die Dispersion **(D)** wird in einer weiteren Ausführungsform der Erfindung zur Herstellung einer Folie zur Verkapselung einer elektronischen Vorrichtung verwendet.

Die vorliegende Erfindung umfasst demnach auch ein erstes Verfahren zur Herstellung einer Folie zur Verkapselung einer elektronischen Vorrichtung umfassend
(a) Vermischen der Dispersion **(D)** mit weiterem Polyolefincopolymer **(I)** zu einer Mischung;
(b) extrudieren der in Schritt (a) erhaltenen Mischung zu einer Folie.

Das in Schritt (a) des erfindungsgemäßen ersten Verfahrens zur Herstellung einer Folie zur Verkapselung einer elektronischen Vorrichtung zugegebene weitere Polyolefincopolymer kann gleich oder verschieden sein wie das von der in Schritt (a) des erfindungsgemäßen Verfahrens eingesetzten Dispersion **(D)** umfasste Polyolefincopolymer, bevorzugt ist es jedoch gleich und bevorzugter sind beide Ethylen-Vinylacetat-Copolymer, noch bevorzugter mit dem gleichen Vinylacetat -Gehalt.

Die Menge des Polyolefincopolymer, welches in Schritt (a) des erfindungsgemäßen ersten Verfahrens zur Herstellung einer Folie zur Verkapselung einer elektronischen Vorrichtung zugegeben wird, ist nicht besonders beschränkt. Insbesondere wird so viel Polyolefincopolymer zugegeben, dass das in der in Schritt (b) extrudierten Folie gewünschte Verhältnis von Polyolefincopolymer **(I)** zu Verbindung der chemischen Struktur **(II)** eingestellt wird. Bevorzugt wird, wenn in der in Schritt (a) des Verfahrens zur Herstellung einer Folie zur Verkapselung einer elektronischen Vorrichtung eingesetzten Dispersion **(D)** der Anteil an allen Verbindungen der chemischen Struktur **(II)** bezogen auf das Gesamtgewicht aller von der Dispersion **(D)** umfassten Polyolefincopolymere (I) im Bereich 0.1 bis 25.0 Gew.-%, bevorzugter bei 1.0 bis 11.1 Gew.-%, noch bevorzugter bei 2.0 bis 10.0 Gew.-%, noch mehr bevorzugter bei 3.0 bis 9.0 Gew.-%, am bevorzugtesten bei 5.3 bis 8.1 Gew.-% liegt, soviel weiteres Polyolefincopolymer **(I)** zugegeben, dass das Verhältnis an allen in Schritt (a) des erfindungsgemäßen Verfahrens vermischten Verbindungen der chemischen Struktur **(II)** bezogen auf das Gesamtgewicht aller in der in Schritt (a) des erfindungsgemäßen Verfahrens vermischten Polyolefincopolymere **(I)** im Bereich von 0.01 bis 8.0 Gew.-% liegt. Es versteht sich von selbst, dass gleichzeitig das Verhältnis an allen in Schritt (a) des erfindungsgemäßen Verfahrens vermischten Verbindungen der chemischen Struktur **(II)** bezogen auf das Gesamtgewicht aller in der in Schritt (a) des erfindungsgemäßen Verfahrens vermischten Polyolefincopolymere **(I)** geringer ist als der Anteil an allen Verbindungen der chemischen Struktur **(II)** in der in Schritt (a) eingesetzten Dispersion **(D)** bezogen auf das Gesamtgewicht aller von der in Schritt (a) eingesetzten Dispersion **(D)** umfassten Polyolefincopolymere **(I).**

In einer besonderen Ausführungsform des erfindungsgemäßen ersten Verfahrens zur Herstellung einer Folie zur Verkapselung einer elektronischen Vorrichtung werden in Schritt (a) weitere Additive zugegeben. Diese Additive sind erfindungsgemäß ausgewählt aus der Gruppe bestehend aus Initiatoren, weiteren Vernetzern, Silankupplungsmitteln, Antioxidantien, Alterungsschutzmittel, Metalloxiden, Metallhydroxiden, Weißpigmenten. Noch bevorzugter sind die Additive ausgewählt aus der Gruppe bestehend aus) Initiatoren (beispielsweise *tert*-Butylperoxy-2-ethylhexylcarbonat), weiteren Vernetzern (beispielsweise Triallylisocyanurat), Silankupplungsmitteln (beispielsweise γ-Methacryloxypropyltrimethoxysilan).

Initiatoren sind erfindungsgemäß durch Wärme, Licht, Feuchtigkeit oder Elektronenstrahlen aktivierbare Radikalbildner.

Der Initiator ist bevorzugt ausgewählt aus der Gruppe bestehend aus peroxidischen Verbindungen, Azoverbindungen, Photoinitiatoren. Bevorzugter ist der Initiator ausgewählt aus der Gruppe bestehend aus peroxidischen Verbindungen, Azoverbindungen. Beispiele dafür sind in der *"*Encyclopedia of Chemical Technology 1992, 3rd Edition, Vol. 17, Seiten 27- 90" beschrieben.

Peroxidische Verbindungen sind insbesondere organische Peroxide, welche wiederum ausgewählt sind aus der Gruppe bestehend aus Dialkylperoxiden, Diperoxyketalen, Peroxycarbonsäureestern, Peroxycarbonaten.

Dialkylperoxide sind insbesondere ausgewählt aus der Gruppe bestehend aus Dicumylperoxid, Di-*tert*-butylperoxid, Di-*tert*-Hexylperoxid, *tert*-Butylcumylperoxid, *iso*-Propylcumyl-*tert*-butylperoxid, *tert*-Hexylcumylperoxid, 2,5-Dimethyl-2,5-di(*tert*-butylperoxy)-hexan, 2,5-Dimethyl-2,5-di(*tert*-amylperoxy)-hexan, 2,5-Dimethyl-2,5-di(*tert*-butylperoxy)-hex-3-in, 2,5-Dimethyl-2,5-di(*tert*-amylperoxy)-hex-3-in, α,α-Di[(*tert*-butylperoxy)-*iso*-propyl]-benzol, Di-*tert*-amylperoxid, 1,3,5-Tri-[(*tert*-butylperoxy)-isopropyl]-benzol, 1,3-Dimethyl-3-(*tert*-butylperoxy)-butanol, 1,3-dimethyl-3-(*tert*-amylperoxy)-butanol, *iso*-Propylcumylhydroperoxid.

Diperoxyketale sind insbesondere ausgewählt aus der Gruppe bestehend aus 1,1-Di(*tert*-butylperoxy)-3,3,5-trimethylcyclohexan, 1,1-Di(*tert*-amylperoxy)-cyclohexan, 1,1-Di(*tert*-butylperoxy)-cyclohexan, *n*-Butyl-4,4-di(*tert*-amylperoxy)-valerat, Ethyl-3,3-di(*tert*-butylperoxy)-butyrat, 2,2-Di(*tert*-butylperoxy)butan, 3,6,6,9,9-Pentamethyl-3-ethoxycarbonylmethyl-1,2,4,5-tetraoxacyclononan, 2,2-Di(*tert*-amylperoxy)-propan, *n*-Butyl-4,4-bis(*tert*-butylperoxy)-valerat.

Peroxycarbonsäureester sind insbesondere ausgewählt aus der Gruppe bestehend aus *tert*-Amylperoxyacetat, *tert*-Butylperoxy-3,5,5-trimethylhexanoat, *tert*-Amylperoxybenzoat, *tert*-Butylperoxyacetat, *tert*-Butylperoxybenzoat, *OO*-*tert*-Butylmonoperoxysuccinat, *OO-tert*-Amylmonoperoxysuccinat.

Peroxycarbonate sind insbesondere ausgewählt aus der Gruppe bestehend aus *tert*-Butylperoxy-2-ethylhexylcarbonat, *tert*-Butylperoxy-*iso*-propylcarbonat, *tert*-Amylperoxy-2-ethylhexyl-carbonat, *tert*-Amylperoxybenzoat. Ein bevorzugtes Peroxycarbonat ist *tert*-Butylperoxy-2-ethylhexylcarbonat ("TBPEHC").

Die Azoverbindung ist bevorzugt ausgewählt aus der Gruppe bestehend aus 2,2'-Azobis-(2-acetoxypropan), 1,1'-Azodi(hexahydrobenzonitril).

Besonders bevorzugt ist der Initiator ausgewählt aus der Gruppe bestehend aus 2,5-Dimethyl-2,5-di(*tert*-butylperoxy)-hexan, *tert*-Butylperoxy-2-ethylhexylcarbonat, *tert*-Butylperoxy-3,5,5-trimethylhexanoat, 1,1-Di(*tert*-butylperoxy)-3,5,5-trimethylcyclohexan, *tert*-Amylperoxy-2-ethylhexylcarbonat; am bevorzugtesten ist der Initiator *tert*-Butylperoxy-2-ethylhexylcarbonat ("TBPEHC").

Die Masse der peroxidischen Verbindung oder der Azoverbindung, bevorzugt der peroxidischen Verbindung, welche bezogen auf die Masse des Polyolefincopolymers eingesetzt wird, ist nicht besonders beschränkt. Die peroxidische Verbindung oder die Azoverbindung, bevorzugt die peroxidische Verbindung, wird insbesondere in einer Menge von 0.05 bis 10 Gew.-%, bevorzugt 0.1 bis 5 Gew.-%, bevorzugter 0.5 bis 2 Gew.-%, jeweils bezogen auf die Masse aller in Schritt (a) des erfindungsgemäßen Verfahrens vermischten Polyolefincopolymere **(I),** eingesetzt.

Photoinitiatoren sind insbesondere ausgewählt aus der Gruppe bestehend aus Benzophenon, Benzanthron, Benzoin, Benzoinalkylether, 2,2-Diethoxyacetophenon, 2,2-Dimethoxy-2-phenylacetophenon, *p*-Phenoxydichloracetophenon, 2-Hydroxycyclohexylphenon, 2-Hydroxyisopropylphenon, 1-Phenylpropandion-2-(ethoxycarbonyl)-oxim.

Der Photoinitiator wird insbesondere in einer Menge von 0.05 bis 10 Gew.-%, bevorzugt 0.1 bis 5 Gew.-%, bevorzugter 0.2 bis 3 Gew.-%, noch bevorzugter 0.25 bis 1 Gew.-%, jeweils bezogen auf die Masse aller in Schritt (a) des erfindungsgemäßen Verfahrens vermischten Polyolefincopolymere **(I),** eingesetzt.

Der Begriff "weiterer Vernetzer" impliziert dabei im Sinne der Erfindung, dass es sich bei diesem Vernetzer nicht um eine Verbindung der chemischen Struktur **(II)** handelt.

Vernetzer sind dabei bevorzugt ausgewählt aus der Gruppe bestehend aus Triallylisocyanurat, Triallylcyanurat, Trimethylolpropantriacrylat, Trimethylolpropantrimethacrylat, Divinylbenzol, Acrylate und Methacrylate von polyhydrischen Alkoholen. Acrylate und Methacrylate von polyhydrischen Alkoholen sind insbesondere ausgewählt aus der Gruppe bestehend aus Ethylenglycoldi(meth)acrylat, Diethylenglycoldi(meth)acrylat, Polyethylenglycoldi(meth)acrylat, Neopentylglycoldi(meth)acrylat, 1,6-Hexandioldi(meth)acrylat, 1,9-Nonandioldi(meth)acrylat, 1,10-Decandioldi(meth)acrylat. Besonders bevorzugt ist der weitere Vernetzer Triallylisocyanurat.

Der Anteil der in Schritt (a) des erfindungsgemäßen Verfahrens eingesetzten Vernetzer ist dabei nicht besonders beschränkt. Der Vernetzer wird insbesondere in einer Menge von 0.005 bis 5 Gew.-%, bevorzugt 0.01 bis 3 Gew.-%, bevorzugter 0.05 bis 3 Gew.-%, noch bevorzugter 0.1 bis 1.5 Gew.-%, jeweils bezogen auf die Masse aller in Schritt (a) des erfindungsgemäßen Verfahrens vermischten Polyolefincopolymere **(I),** eingesetzt.

Als erfindungsgemäß einsetzbare Silankupplungsmittel kommen alle Silane in Betracht, welche einen ungesättigten Kohlenwasserstoffrest und einen hydrolysierbaren Rest aufweisen (beschrieben etwa in EP 2 436 701 B1, US 5,266,627).

Ungesättigte Kohlenwasserstoffreste sind insbesondere ausgewählt aus der Gruppe bestehend aus Vinyl, Allyl, Isopropenyl, Butenyl, Cyclohexenyl, γ-(Meth)acryloxyallyl.

Hydrolisierbarer Reste sind insbesondere ausgewählt aus der Gruppe bestehend aus Hydrocarbyloxy, Hydrocarbonyloxy, Hydrocarbylamino. Bevorzugt ist der hydrolysierbare Rest ausgewählt aus der Gruppe bestehend aus Methoxy, Ethoxy, Formyloxy, Acetoxy, Proprionyloxy, Alkylamino, Arylamino.

Bevorzugt ist das Silankupplungsmittel ausgewählt aus der Gruppe bestehend aus: Vinyltriethoxysilan, Vinyltris-(β-methoxyethoxy)silan, Vinyltriacetoxysilan, γ-Acryloxypropyltrimethoxysilan, γ-Methacryloxypropyltrimethoxysilan, *N*-(β-aminoethyl)-γ-aminopropyltrimethoxysilan, *N*-(β-Aminoethyl)-γ-aminopropylmethyldimethoxysilan, γ-Aminopropyltriethoxysilan, γ-Glycidoxypropyltrimethoxysilan, γ-Mercaptopropyltriethoxysilan, γ-Chlorpropyltrimetoxysilan, β-(3,4-Ethoxycyclohexyl)-ethyltrimethoxysilan, γ-Mercaptopropyltrimethoxysilan. Besonders bevorzugt wird als Silankupplungsmittel γ-Methacryloxypropyltrimethoxysilan (abgekürzt als "KBM") eingesetzt.

Der Anteil der in Schritt (a) des erfindungsgemäßen Verfahrens eingesetzten weiteren Vernetzers ist dabei nicht besonders beschränkt. Das Silankupplungsmittel wird insbesondere in einer Menge von 0.05 bis 5 Gew.-%, bevorzugt 0.1 bis 2 Gew.-%, jeweils bezogen auf die Masse aller in Schritt (a) des erfindungsgemäßen Verfahrens vermischten Polyolefincopolymere **(I),** eingesetzt.

Antioxidantien sind im Sinne der Erfindung bevorzugt ausgewählt aus der Gruppe bestehend aus phenolischen Antioxidantien, phosphorhaltigen Antioxidantien.

Phenolische Antioxidantien sind insbesondere ausgewählt aus der Gruppe bestehend aus 4-Methoxyphenol, 2,6-Di-*tert*-butyl-4-methylphenol, *tert*-Butylhydrochinon, Stearyl-β-(3,5-di-*tert*-butyl-4-hydroxyphenyl)-propionat, Pentaerythrittetrakis-[3-(3,5-di-*tert*-butyl-4-hydroxyphenyl)-propionat], 3,5-Di-*tert*-butyl-4-hydroxybenzoesäurehexadecylester.

Phosphorhaltige Antioxidantien sind insbesondere ausgewählt aus der Gruppe bestehend aus Triphenylphosphit, Tris-(nonylphenyl)-phosphit, Distearylpentaerythritoldiphosphit, Tetra-(tridecyl)-1,1,3-tris-(2-methyl-5-*tert*-butyl-4-hydroxyphenyl)-butan-diphosphat, Tetrakis-(2,4-di-*tert*-butylphenyl)-4,4-biphenyldiphosphonit.

Der Anteil in Schritt (a) des erfindungsgemäßen Verfahrens eingesetzten Antioxidantien ist dabei nicht besonders beschränkt. Die Antioxidantien werden insbesondere in einer Menge von 0.01 bis 0.5 Gew.-%, bevorzugt 0.05 bis 0.3 Gew.-%, jeweils bezogen auf die Masse aller in Schritt (a) des erfindungsgemäßen Verfahrens vermischten Polyolefincopolymere (I), eingesetzt.

Alterungsschutzmittel sind im Sinne der Erfindung insbesondere ausgewählt aus der Gruppe der*"hindered amine light stabilizers"* (= "HALS")-Stabilisatoren und der UV-Absorber.

HALS-Stabilisatoren sind im Sinne der Erfindung insbesondere Verbindungen, die mindestens einen 2,2,6,6-Tetramethyl-4-piperidyl-Rest aufweisen, wobei das Stickstoffatom an der 1-Position des Piperidylrestes ein H, eine Alkylgruppe oder eine Alkoxygruppe trägt.

Bevorzugt sind HALS-Stabilisatoren ausgewählt aus der Gruppe bestehend aus Bis(2,2,6,6-tetramethyl-4-piperidyl)-sebacat, 1,2,2,6,6-Pentamethyl-4-piperidylsebacat, Bis(1,2,2,6,6-pentamethyl-4-piperidyl)-sebacat, Bis-(1-octyloxy-2,2,6,6-tetramethyl-4-piperidyl)-sebacat, Poly-{(6-morpholino-S-triazin-2,4-diyl)-[2,2,6,6-tetramethyl-4-piperidyl)-imino]-hexamethylen-[(2,2,6 ,6-tetramethyl-4-piperidyl)-imino]} mit der CAS-Nummer 82451-48-7, Polymere der CAS-Nummer 193098-40-7, Copolymer aus Dimethylsuccinat und 1-(2-Hydroxyethyl)-2,2,6,6-tetramentyl-4-piperidinol, *N*,*N*',*N*",*N'"*-Tetrakis-{4,6-bis-[butyl-(*N*-methyl-2,2,6,6-tetramethylpiperidin-4-yl)-amino]-triazin-2-yl}-4,7-diazadecan-1,10-diamin mit der CAS-Nummer 106990-43-6.

Der Anteil in Schritt (a) des erfindungsgemäßen Verfahrens eingesetzten HALS-Stabilisatoren ist dabei nicht besonders beschränkt. Die HALS-Stabilisatoren werden insbesondere in einer Menge von 0.01 bis 0.5 Gew.-%, bevorzugt 0.05 bis 0.3 Gew.-%, jeweils bezogen auf die Masse aller in Schritt (a) des erfindungsgemäßen Verfahrens vermischten Polyolefincopolymere **(I),** eingesetzt.

UV-Absorber sind insbesondere ausgewählt aus der Gruppe bestehend aus 2-Hydroxy-4-*N*-octoxybenzophenon, 2,4-Di-*tert*-butylphenyl-3,5-di-*tert*-butyl-4-hydroxybenzoat, 2-Hydroxy-4-methoxybenzophenon, 2,2-Dihydroxy-4-methoxybenzophenon, 2-Hydroxy-4-methoxy-4-carboxybenzophenon, 2-(2-Hydroxy-3,5-di-*tert*-butylphenyl)-benzotriazol, 2-(2-Hydroxy-5-methylphenyl)-benzotriazol, p-Octyl-phenyl salicylat, 2-(4,6-Diphenyl-1,3,5-triazine-2-yl)-5-[(hexyl)-oxy]-phenol, Ethyl-2-cyano-3,3-diphenyl-acrylat.

Der Anteil der von der Zusammensetzung **(B)** umfassten UV-Absorber ist dabei nicht besonders beschränkt. Der Anteil aller von der Zusammensetzung **(B)** umfassten UV-Absorber liegt insbesondere bei 0.01 bis 0.5 Gew.-%, bevorzugt 0.05 bis 0.3 Gew.-%, jeweils bezogen auf die Masse aller von der Zusammensetzung **(B)** umfassten Polyolefincopolymere.

Metalloxide sind erfindungsgemäß insbesondere ausgewählt aus der Gruppe bestehend aus Alkalimetalloxiden, Erdalkalimetalloxiden, Zinkoxid, bevorzugt ausgewählt aus der Gruppe bestehend aus Magnesiumoxid, Zinkoxid.

Der Anteil der in Schritt (a) des erfindungsgemäßen Verfahrens eingesetzten Metalloxide ist dabei nicht besonders beschränkt. Die Metalloxide werden insbesondere in einer Menge von 0.01 bis 10 Gew.-%, bevorzugt 0.05 bis 3 Gew.-%, jeweils bezogen auf die Masse aller in Schritt (a) des erfindungsgemäßen Verfahrens vermischten Polyolefincopolymere **(I),** eingesetzt.

Metallhydroxide sind erfindungsgemäß insbesondere ausgewählt aus der Gruppe bestehend aus Alkalimetallhydroxiden, Erdalkalimetallhydroxiden, bevorzugt ausgewählt aus der Gruppe bestehend aus Magnesiumhydroxid, Calciumhydroxid.

Der Anteil der in Schritt (a) des erfindungsgemäßen Verfahrens eingesetzten Metallhydroxide ist dabei nicht besonders beschränkt. Die Metallhydroxide werden insbesondere in einer Menge von 0.01 bis 10 Gew.-%, bevorzugt 0.05 bis 3 Gew.-%, jeweils bezogen auf die Masse aller in Schritt (a) des erfindungsgemäßen Verfahrens vermischten Polyolefincopolymere **(I),** eingesetzt.

Weißpigmente sind im Sinne der Erfindung insbesondere ausgewählt aus der Gruppe Titandioxid, Zinkoxid, Zinksulfid, Bariumsulfat, Lithopone.

Der Anteil der in Schritt (a) des erfindungsgemäßen Verfahrens eingesetzten Weißpigmente ist dabei nicht besonders beschränkt. Die Weißpigmente werden insbesondere in einer Menge von 5 bis 25 Gew.-%, bevorzugt 10 bis 20 Gew.-%, noch bevorzugter bei 15 Gew.-%, jeweils bezogen auf die Masse aller in Schritt (a) des erfindungsgemäßen Verfahrens vermischten Polyolefincopolymere **(I),** eingesetzt.

Die beiden Schritte des erfindungsgemäßen ersten Verfahrens zur Herstellung einer Folie zur Verkapselung einer elektronischen Vorrichtung können nachdem Fachmann geläufigen Verfahren durchgeführt werden.

So können in einer Ausführungsform die Schritte (a) und (b) getrennt durchgeführt werden. Dies geschieht insbesondere durch Vermischen der Dispersion **(D)** in Granulatform mit weiterem Polyolefincopolymer **(I),** ebenfalls in Granulatform, und gegebenenfalls weiteren Additiven in einem Mischer [Schritt (a)], gefolgt von der Dosierung der in Schritt (a) erhaltenen Mischung in einen Extruder, in welchem diese Mischung aufgeschmolzen, homogen gemischt und zu einer Folie extrudiert wird.

Alternativ, und bevorzugt, finden Schritt (a) und Schritt (b) in einem Verfahrensschritt statt, wobei Dispersion **(D)** in Granulatform mit weiterem Polyolefincopolymer **(I),** ebenfalls in Granulatform und gegebenenfalls schon umfassend die Additive, gleichzeitig und unabhängig voneinander in einen Extruder dosiert werden, dort vermischt werden und die so erhaltene Mischung aufgeschmolzen, homogenisiert und zu einer Folie extrudiert wird.

Die erfindungsgemäße Dispersion **(D)** wird insbesondere durch ein Verfahren zur Herstellung der Dispersion **(D)** erhalten, was die folgenden Schritte umfasst:
(a) Bereitstellen eines Polyolefincopolymers **(I);**
(b) Zugabe mindestens einer pulverförmigen Verbindung der chemischen Struktur **(II)** zum Polyolefincopolymer **(I)** mit 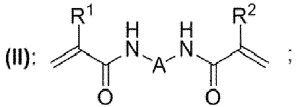 wobei
   R¹, R² unabhängig voneinander jeweils Wasserstoff oder Methyl ist;
   A ausgewählt ist aus der Gruppe bestehend aus
   unverzweigte oder verzweigte Alkylengruppe mit 1 bis 20 Kohlenstoffatomen, bei welcher mindestens ein Wasserstoffrest durch einen Halogenrest substituiert sein kann und bei welcher ein oder zwei Wasserstoffreste durch jeweils einen Rest ausgewählt aus der Gruppe bestehend aus -OR³, -C(=O)NR⁴R⁵ substituiert sein können,
   Arylengruppe mit 6 bis 14 Kohlenstoffatomen, bei welcher mindestens ein Wasserstoffrest durch einen Halogenrest oder einen Alkylrest mit 1 bis 10 Kohlenstoffatomen substituiert sein kann und bei welcher ein oder zwei Wasserstoffreste durch jeweils einen Rest ausgewählt aus der Gruppe bestehend aus -OR⁶, -C(=O)NR⁷R⁸ substituiert sein können,
   ein verbrückender Rest der chemischen Struktur -A¹-X-A²-;
   wobei R³, R⁴, R⁵, R⁶, R⁷, R⁸ unabhängig voneinander jeweils ausgewählt aus der Gruppe bestehend aus Wasserstoff, verzweigter oder unverzweigter Alkylrest mit 1 bis 10 Kohlenstoffatome sind;
   wobei A¹, A² unabhängig voneinander jeweils eine verzweigte oder unverzweigte Alkylengruppe mit 1 bis 10 Kohlenstoffatomen ist;
   und wobei X ausgewählt aus der Gruppe bestehend aus -O-, -S-S-, -S-, -NR⁹- mit R⁹ = Alkylrest mit 1 bis 10 Kohlenstoffatomen ist;
(c) Einarbeiten der Verbindung der chemischen Struktur **(II)** in das Polyolefincopolymer (I).

Die Einarbeitung in Schritt (c) kann nach dem Fachmann bekannten Verfahren geschehen, wie zum Beispiel in kontinuierlichen Mischaggregaten , wie zum Beispiel Einschnecken-, Doppelschneckenextruder oder Buss-Koknetern oder in diskontinuierlichen Knetern oder Innenmischern. Dies stellt sicher, dass die pulverförmigen Verbindung der chemischen Struktur **(II)** in dem Polyolefincopolymer dispergiert wird.

Um die Einarbeitung der pulverförmigen Verbindung der chemischen Struktur **(II)** in Schritt (c) des Verfahrens zur Herstellung der Dispersion **(D)** zu verbessern, weist die in Schritt (b) eingesetzte pulverförmigen Verbindung der chemischen Struktur **(II)** insbesondere eine Partikelgröße wie folgt auf: Mindestens 50 % aller von der pulverförmigen Verbindung der chemischen Struktur **(II)** umfassten Partikel haben einen Partikelgröße von ≤ 500 µm bevorzugt von ≤ 400 µm, noch bevorzugter ≤ 250 µm, am bevorzugtesten ≤ 220 µm (auch abgekürzt als "d₅₀"-Wert). Die Partikelgröße wird dabei bestimmt gemäß DIN/ISO 13320. Noch bevorzugter haben sämtliche Partikel der in Schritt (b) eingesetzten pulverförmigen Verbindung der chemischen Struktur **(II)** eine Partikelgröße ≤ 2 mm.

Es ist zu beachten, dass durch Scherkräfte während der Einarbeitung in Schritt (c) des Verfahrens zur Herstellung der Dispersion **(D)** die Partikelgröße der pulverförmigen Verbindung der chemischen Struktur **(II)** verkleinert wird. Das Ergebnis ist, dass die Partikelgröße der Partikel der dispergierten Verbindung der chemischen Struktur **(II)** im Durchschnitt kleiner ist als die der Partikel der eingesetzten pulverförmigen Verbindung der chemischen Struktur **(II).**
Die vorliegende Erfindung betrifft auch eine Dispersion **(D),** erhältlich nach dem erfindungsgemäßen Verfahren zur Herstellung einer Dispersion **(D),** sowie die Verwendung dieser Dispersion **(D)** zur Herstellung einer Folie zur Verkapselung einer elektronischen Vorrichtung.

Natürlich kann die nach dem erfindungsgemäßen Verfahren zur Herstellung einer Dispersion **(D)** erhaltene Dispersion **(D)** auch in Schritt (a) des erfindungsgemäßen Verfahrens zur Herstellung einer Folie zur Verkapselung einer elektronischen Vorrichtung eingesetzt werden.

Die Erfindung betrifft demnach auch ein weiteres, zweites Verfahren zur Herstellung einer Folie zur Verkapselung einer elektronischen Vorrichtung umfassend
(a) Vermischen der Dispersion **(D),** erhältlich nach dem erfindungsgemäßen Verfahren zur Herstellung einer Dispersion **(D),** mit weiterem Polyolefincopolymer (I) zu einer Mischung;
(b) extrudieren der in Schritt (a) erhaltenen Mischung zu einer Folie.

Bevorzugt werden dabei in Schritt (a) des zweiten Verfahrens zur Herstellung einer Folie zur Verkapselung einer elektronischen Vorrichtung weitere Additive ausgewählt aus der Gruppe bestehend aus Initiatoren, weiteren Vernetzern, Silankupplungsmitteln, Antioxidantien, Alterungsschutzmittel, Metalloxiden, Metallhydroxiden, Weißpigmenten zugegeben. Diese Additive haben die für das erfindungsgemäße erste Verfahren zur Herstellung einer Folie zur Verkapselung einer elektronischen Vorrichtung beschriebenen Bedeutungen und bevorzugten Ausführungsformen.

Die beiden Schritte des erfindungsgemäßen zweiten Verfahrens zur Herstellung einer Folie zur Verkapselung einer elektronischen Vorrichtung können nach dem Fachmann geläufigen Verfahren durchgeführt werden.

So kann in einer Ausführungsform des zweiten Verfahrens zur Herstellung einer Folie zur Verkapselung einer elektronischen Vorrichtung Schritte (a) und (b) getrennt durchgeführt werden. Dies geschieht insbesondere durch Vermischen der Dispersion **(D),** erhältlich nach dem erfindungsgemäßen Verfahren zur Herstellung einer Dispersion **(D),** in Granulatform mit weiterem Polyolefincopolymer (I), ebenfalls in Granulatform, und gegebenenfalls weiteren Additiven in einem Mischer [Schritt (a)], gefolgt von der Dosierung der in Schritt (a) erhaltenen Mischung in einen Extruder, in welchem diese Mischung aufgeschmolzen, homogen gemischt und zu einer Folie extrudiert wird.

Alternativ, und bevorzugt, finden Schritt (a) und Schritt (b) in einem Verfahrensschritt statt, wobei bevorzugter Dispersion **(D),** erhältlich nach dem erfindungsgemäßen Verfahren zur Herstellung einer Dispersion **(D),** in Granulatform mit weiterem Polyolefincopolymer **(I),** ebenfalls in Granulatform und gegebenenfalls schon umfassend die Additive, gleichzeitig und unabhängig voneinander in einen Extruder dosiert werden, dort vermischt werden und die so erhaltene Mischung aufgeschmolzen, homogenisiert und zu einer Folie extrudiert wird.

Die nachfolgenden Beispiele sollen die vorliegende Erfindung weiter erläutern, ohne dass diese auf diese Beispiele beschränkt sein soll.

### Beispiele

### 1. Verwendete Chemikalien

*N,N*-Methylendiacrylamid (= "MDAA") wurde bezogen von Merck. Die Dichte beträgt 1.235 g/cm³ (30 °C), die Schüttdichte des Produktes war 200 kg / m³. Die Partikelgrößenverteilung betrug: d₅₀ = 220 µm (Gerät: Beckman Coulter LS Partikelgrößenmessgerät).

Bei dem im Folgenden verwendeten Triallylisocyanurat handelte es sich um "TAICROS ®" der Evonik Industries AG.

Bei dem im Folgenden verwendeten γ-Methacryloxypropyltrimethoxysilan (="KBM") handelte es sich um "Dynasylan Memo ®" der Evonik Industries AG.

Das im Folgenden verwendete *tert*-Butylperoxy-2-ethylhexylcarbonat (="TBPEHC") wurde von der Firma United Initiators bezogen.

Bei dem im Folgenden verwendeten EVA handelte es sich um "EVATANE 28-40" ® von Arkema mit einem Gehalt an Vinylacetat von 28.3 Gew.-%.

### 2. Herstellung der Masterbatches

### 2.1. Herstellung des Masterbatches zu Beispiel 1

Zur Herstellung des Masterbatches mit einer MDAA-Konzentration von 1.0 % wurden 5.0 kg EVA-Granulat mit 50 g MDAA in einem ThermoHaake PTW 16/25D extrudiert. Das EVA-Granulat wurde volumetrisch mit der Dosiereinheit Brabender DDS 20 zudosiert, das MDAA über eine gravimetrische Pulverdosiereinheit (Brabender MiniTwin) zugeführt. Der Masterbatch wurde nach Düsenaustritt in einem Wasserbad auf 20 °C abgekühlt und über einen Stranggranulator granuliert.

### 2.2 Herstellung des Masterbatches zu Beispielen 2 und 5

Zur Herstellung des Masterbatches mit einer MDAA-Konzentration von 5.3 % wurden 5.0 kg EVA-Granulat mit 265 g MDAA in einem ThermoHaake PTW 16/25D extrudiert. Das EVA-Granulat wurde volumetrisch mit der Dosiereinheit Brabender DDS 20 zudosiert, das MDAA über eine gravimetrische Pulverdosiereinheit (Brabender MiniTwin) zugeführt. Der Masterbatch wurde nach Düsenaustritt in einem Wasserbad auf 20 °C abgekühlt und über einen Stranggranulator granuliert.

### 2.3. Herstellung des Masterbatches zu Beispielen 3 und 6

Zur Herstellung des Masterbatches mit einer MDAA-Konzentration von 8.1 % wurden 5.0 kg EVA-Granulat mit 405 g MDAA in einem ThermoHaake PTW 16/25D extrudiert. Das EVA-Granulat wurde volumetrisch mit der Dosiereinheit Brabender DDS 20 zudosiert, das MDAA über eine gravimetrische Pulverdosiereinheit (Brabender MiniTwin) zugeführt. Der Masterbatch wurde nach Düsenaustritt in einem Wasserbad auf 20 °C abgekühlt und über einen Stranggranulator granuliert.

### 2.4. Herstellung des Masterbatches zu Beispiel 4

Zur Herstellung des Masterbatches mit einer MDAA-Konzentration von 25.0 % wurden 5.0 kg EVA-Granulat mit 1.25 kg MDAA in einem ThermoHaake PTW 16/25D extrudiert. Das EVA-Granulat wurde volumetrisch mit der Dosiereinheit Brabender DDS 20 zudosiert, das MDAA über eine gravimetrische Pulverdosiereinheit (Brabender MiniTwin) zugeführt. Der Masterbatch wurde nach Düsenaustritt in einem Wasserbad auf 20 °C abgekühlt und über einen Stranggranulator granuliert.

### 3. Vorbereitung des EVA-Granulats für die EVA-Filmherstellung

### Vergleichsbeispiele:

### Beispiel V1

Eine Mischung aus 2.02 g (8.11 mmol) TAIC, 0.50 g KBM und 4.0 g TBPEHC wurde auf 493.5 g EVA gleichmäßig verteilt. Die EVA-Additivmischung wurde anschließend für 2 bis 4 h in einem Taumelmischer durchmischt.

### Beispiel V2

1.25 g (8.11 mmol) MDAA wurden in einer Mischung aus 0.50 g KBM, 4.0 g TBPEHC und 15 g Methanol gelöst. Die Mischung wurde auf 494.25 g EVA gleichmäßig verteilt. Die EVA-Additivmischung wurde anschließend für 2 bis 4 h in einem Taumelmischer durchmischt und anschließend eine Stunde im Vakuumtrockenschrank bei 35 °C getrocknet, um das Methanol zu entfernen.

### Beispiel V3

0.25 g (1.62 mmol) MDAA wurden in einer Mischung aus 2.25 g (9.03 mmol) TAIC, 0.50 g KBM, 4.0 g TBPEHC und 1.7 g Methanol gelöst. Die Mischung wurde auf 493 g EVA gleichmäßig verteilt. Die EVA-Additivmischung wurde anschließend für 2 bis 4 h in einem Taumelmischer durchmischt und anschließend eine Stunde im Vakuumtrockenschrank bei 35 °C getrocknet, um das Methanol zu entfernen.

### Beispiel V4

0.5 g (3.24 mmol) MDAA wurden in einer Mischung aus 2.0 g (8.02 mmol) TAIC, 0.50 g KBM, 4.15 g TBPEHC und 1.73 g Methanol gelöst. Die Mischung wurde auf 493 g EVA gleichmäßig verteilt. Die EVA-Additivmischung wurde anschließend für 2 bis 4 h in einem Taumelmischer durchmischt und anschließend eine Stunde im Vakuumtrockenschrank bei 35 °C getrocknet, um das Methanol zu entfernen.

### Erfindungsgemäße Beispiele 1 - 6

### Beispiel 1

2.25 g TAIC, 0.5 g KBM und 4 g TBPEHC wurden vermischt und gleichmäßig auf eine Granulatmischung, bestehend aus 25 g des wie in Abschnitt 2.1 beschrieben hergestellten Masterbatches (im Folgenden abgekürzt als "MB") und 468.25 g EVA verteilt. Die erhaltene EVA/MB-Additivmischung wurde anschließend für 2 - 4 h in einem Taumelmischer durchmischt.

### Beispiel 2

2.25 g TAIC, 0.5 g KBM und 4 g TBPEHC wurden vermischt und gleichmäßig auf eine Granulatmischung, bestehend aus 5.0 g des wie in Abschnitt 2.2 beschrieben hergestellten Masterbatches und 488.25 g EVA verteilt. Die erhaltene EVA/MB-Additivmischung wurde anschließend für 2 - 4 h in einem Taumelmischer durchmischt.

### Beispiel 3

2.25 g TAIC, 0.5 g KBM und 4 g TBPEHC wurden vermischt und gleichmäßig auf eine Granulatmischung, bestehend aus 2.5 g des wie in Abschnitt 2.3 beschrieben hergestellten Masterbatches und 490.70 g EVA verteilt. Die erhaltene EVA/MB-Additivmischung wurde anschließend für 2 - 4 h in einem Taumelmischer durchmischt.

### Beispiel 4

2.25 g TAIC, 0.5 g KBM und 4 g TBPEHC wurden vermischt und gleichmäßig auf eine Granulatmischung, bestehend aus 1.25 g des wie in Abschnitt 2.4 beschrieben hergestellten Masterbatches und 492.0 g EVA verteilt. Die erhaltene EVA/MB-Additivmischung wurde anschließend für 2 - 4 h in einem Taumelmischer durchmischt.

### Beispiel 5

2.0 g TAIC, 0.5 g KBM und 4 g TBPEHC wurden vermischt und gleichmäßig auf eine Granulatmischung, bestehend aus 10.0 g des wie in Abschnitt 2.2 beschrieben hergestellten Masterbatches und 483.53 g EVA verteilt. Die erhaltene EVA/MB-Additivmischung wurde anschließend für 2 - 4 h in einem Taumelmischer durchmischt.

### Beispiel 6

2.25 g TAIC, 0.5 g KBM und 4 g TBPEHC wurden vermischt und gleichmäßig auf eine Granulatmischung, bestehend aus 6.67 g des wie in Abschnitt 2.3 beschrieben hergestellten Masterbatches und 486.87 g EVA verteilt. Die erhaltene EVA/MB-Additivmischung wurde anschließend für 2 - 4 h in einem Taumelmischer durchmischt.

### 4. Folienextrusion

Zur Herstellung von EVA-Folien wurde das im jeweiligen Vergleichsbeispiel V1 - V4 bzw. erfindungsgemäßen Beispiel 1 - 7 konditionierte EVA-Granulat direkt in einen Brabender Einschneckenextruder (19 mm) dosiert. Die EVA Schmelze wurde über eine Breitschlitzdüse (10 cm) mit einstellbarer Spaltdicke verdüst, die Folie kontinuierlich auf einem Walzwerk auf (1.Walze) 50°C, zweite Walze 20° nachgekühlt und anschließend aufgewickelt. Die Extruder-Einstellungen sind nachstehend aufgeführt:

**Extrusionsparameter für EVA-Folienherstellung**

| Temperatur Heizzonen [°C] | |
|---|---|
| T1 | 55 |
| T2 | 75 |
| T3 | 80 |
| T4 | 80 |
| Düse | 82 |
| T(Schmelze) | 84 |

### 5. Folienlamination

Die Lamination der EVA- Folie wurde bei 150 °C (Maschineneinstellung) zwischen Teflontrennfolien durchgeführt, wobei die entsprechende Temperatur über den gesamten Laminationsprozess konstant gehalten wurde. Die Dauer des einstufigen Entgasungsschrittes betrug 100 s. Anschließend wurde die Probe mit einem Anpressdruck von 0.7 kg/cm² verpresst. Die Verweilzeit im Laminator betrug 20 Minuten.

### 6. Bestimmung des spezifischen Widerstands ρ

Für die Bestimmung des Widerstandes von vernetzten, 400 bis 500 µm starken EVA Folien wurden zunächst Proben mit den Abmaßen ca. 8 x 8cm bei Raumtemperatur (22.5 °C) und einer relativen Luftfeuchte von 50 % bis zu 7, mindestens aber für 4 Tage gelagert, um ein konstantes Feuchtigkeitslevel innerhalb des EVA Films zu gewährleisten.

Die Widerstandsmessung wurde mit einem Ohmmeter der Firma Keithley (6517B) und einer entsprechenden Messzelle, ebenfalls von Keithley ("*resistivity test fixture 8009"),* durchgeführt. Nach ASTM D-257 wurde die Probe mit einer Spannung von 500 V für 60 s beaufschlagt und nach dieser Zeit der Strom gemessen. Der Widerstand (VR) lässt sich dann aus den bekannten Größen berechnen und ist in der nachfolgenden Tabelle 1 dargestellt.

**Tabelle 1:**

| Beispiel Nr. | Verhältnis MDAA/ EVA im Masterbatch [Gew-%] | MB Menge [g] | MDAA menge [g] (mmol) | TAIC menge [g] (mmol) | VR * 10¹⁵ [Ohm*cm] | VRₘᵢₙ *10¹⁵ [Ohm*cm] | VRₘₐₓ*10¹⁵ [Ohm*cm] |
|---|---|---|---|---|---|---|---|
| V1 | | | - | 2.02 (8.11) | 2.2 | 1.8 | 2.6 |
| V2 | | | 1.25 (8.11) | - | 39.5 | 18.9 | 64.4 |
| V3 | | | 0.25 (1.62) | 2.25 (9.03) | 18.3 | 13.0 | 22.6 |
| | | | | | | | |
| 1 | 1 | 25.0 | 0.25 (1.62) | 2.25 (9.03) | 15.8 | 14.4 | 18.1 |
| 2 | 5.3 | 5.0 | 0.25 (1.62) | 2.25 (9.03) | 19.2 | 13.6 | 29.1 |
| 3 | 8.1 | 2.5 | 0.25 (1.62) | 2.25 (9.03) | 9.4 | 6.0 | 13.8 |
| 4 | 25 | 1.25 | 0.25 (1.62) | 2.25 (9.03) | 8.3 | 4.1 | 12.9 |
| | | | | | | | |
| V4 | | | 0.50 (3.24) | 2.0 (8.02) | 22.2 | 17.5 | 26.1 |
| 5 | 5.3 | 10.0 | 0.50 (3.24) | 2.0 (8.02) | 61.7 | 52.3 | 82.9 |
| 6 | 8.1 | 6.67 | 0.50 (3.24) | 2.0 (8.02) | 42.4 | 36.7 | 51.0 |

Aus den Ergebnissen der Tabelle folgt, dass
- bei Einsatz eines Masterbatches aus Polyolefincopolymer, gezeigt anhand von EVA, und einer Verbindung der chemischen Struktur **(II),** gezeigt anhand von MDAA, eine Folie hergestellt werden kann, ohne auf die Verwendung eines Lösungsmittels zurückgreifen zu müssen.
- Bestimmte Zusammensetzungen von MDAA zu EVA eine Herstellung von EVA-Folien mit einem VR ermöglichen, der über die gesamte Folie einen ausreichend hohen VR gewährleistet. Das ist zu erkennen an den Werten "VRₘᵢₙ" in Tabelle 1, die für Werte von 1 bis 8.1 sogar höher liegen als bei Verwendung des Lösungsmittels.

Beide Ergebnisse waren völlig überraschend.

## Patentansprüche

1. Dispersion (D) umfassend
(i) mindestens ein Polyolefincopolymer (I) als kontinuierliche Phase; und
(ii) mindestens eine in dem Polyolefincopolymer (I) dispergierte Verbindung der chemischen Struktur **(II)** mit 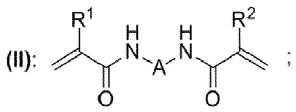 wobei
R¹, R² unabhängig voneinander jeweils Wasserstoff oder Methyl ist;
A ausgewählt ist aus der Gruppe bestehend aus
unverzweigte oder verzweigte Alkylengruppe mit 1 bis 20 Kohlenstoffatomen, bei welcher mindestens ein Wasserstoffrest durch einen Halogenrest substituiert sein kann und bei welcher ein oder zwei Wasserstoffreste durch jeweils einen Rest ausgewählt aus der Gruppe bestehend aus -OR³, -C(=O)NR⁴R⁵ substituiert sein können,
Arylengruppe mit 6 bis 14 Kohlenstoffatomen, bei welcher mindestens ein Wasserstoffrest durch einen Halogenrest oder einen Alkylrest mit 1 bis 10 Kohlenstoffatomen substituiert sein kann und bei welcher ein oder zwei Wasserstoffreste durch jeweils einen Rest ausgewählt aus der Gruppe bestehend aus -OR⁶, -C(=O)NR⁷R⁸ substituiert sein können,
ein verbrückender Rest der chemischen Struktur -A¹-X-A²-;
wobei R³, R⁴, R⁵, R⁶, R⁷, R⁸ unabhängig voneinander jeweils ausgewählt aus der Gruppe bestehend aus Wasserstoff, verzweigter oder unverzweigter Alkylrest mit 1 bis 10 Kohlenstoffatome sind;
wobei A¹, A² unabhängig voneinander jeweils eine verzweigte oder unverzweigte Alkylengruppe mit 1 bis 10 Kohlenstoffatomen ist;
und wobei X ausgewählt aus der Gruppe bestehend aus -O-, -S-S-, -S-, -NR⁹- mit R⁹ = Alkylrest mit 1 bis 10 Kohlenstoffatomen ist.

2. Dispersion **(D)** nach Anspruch 1, wobei R¹ = R² = Wasserstoff und A = -CH₂-.

3. Dispersion **(D)** nach Anspruch 1 oder 2, worin der Anteil an allen Verbindungen der chemischen Struktur **(II)** bezogen auf das Gesamtgewicht aller von der Dispersion **(D)** umfassten Polyolefincopolymere **(I)** im Bereich 0.1 bis 25 Gew.-% liegt.

4. Dispersion **(D)** nach einem der Ansprüche 1 bis 3, wobei das Polyolefincopolymer **(I)** ein Ethylen-Vinylacetat-Copolymer ist.

5. Dispersion **(D)** nach einem der Ansprüche 1 bis 4, worin das Polyolefincopolymer **(I)** im festen Aggregatzustand vorliegt.

6. Dispersion **(D)** nach Anspruch 5, worin die dispergierte Verbindung der chemischen Struktur **(II)** in Partikeln vorliegt, wobei mindestens 50 % aller von der Dispersion **(D)** umfassten Partikel der chemischen Struktur **(II)** eine Partikelgröße von ≤ 100 µm aufweisen.

7. Dispersion **(D)** nach Anspruch 6, worin die dispergierte Verbindung der chemischen Struktur **(II)** in Partikeln vorliegt, wobei alle Partikel eine Partikelgröße von < 1 mm aufweisen.

8. Verwendung einer Dispersion **(D)** nach einem der Ansprüche 1 bis 7 zur Herstellung einer Folie zur Verkapselung einer elektronischen Vorrichtung.

9. Verfahren zur Herstellung einer Folie zur Verkapselung einer elektronischen Vorrichtung umfassend
(a) Vermischen der Dispersion **(D)** gemäß einem der Ansprüche 1 bis 7 mit weiterem Polyolefincopolymer **(I)** zu einer Mischung;
(b) Extrudieren der in Schritt (a) erhaltenen Mischung zu einer Folie.

10. Verfahren nach Anspruch 9, wobei in Schritt (a) weitere Additive ausgewählt aus der Gruppe bestehend aus Initiatoren, weiteren Vernetzern, Silankupplungsmitteln, Antioxidantien, Alterungsschutzmittel, Metalloxiden, Metallhydroxiden, Weißpigmenten zugegeben werden.

11. Verfahren zur Herstellung einer Dispersion **(D),** umfassend die folgenden Schritte:
(a) Bereitstellen eines Polyolefincopolymers **(I);**
(b) Zugabe mindestens einer pulverförmigen Verbindung der chemischen Struktur **(II)** zum Polyolefincopolymer **(I)** mit 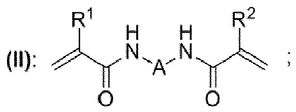 wobei
R¹, R² unabhängig voneinander jeweils Wasserstoff oder Methyl ist;
A ausgewählt ist aus der Gruppe bestehend aus
unverzweigte oder verzweigte Alkylengruppe mit 1 bis 20 Kohlenstoffatomen, bei welcher mindestens ein Wasserstoffrest durch einen Halogenrest substituiert sein kann und bei welcher ein oder zwei Wasserstoffreste durch jeweils einen Rest ausgewählt aus der Gruppe bestehend aus -OR³, -C(=O)NR⁴R⁵ substituiert sein können,
Arylengruppe mit 6 bis 14 Kohlenstoffatomen, bei welcher mindestens ein Wasserstoffrest durch einen Halogenrest oder einen Alkylrest mit 1 bis 10 Kohlenstoffatomen substituiert sein kann und bei welcher ein oder zwei Wasserstoffreste durch jeweils einen Rest ausgewählt aus der Gruppe bestehend aus -OR⁶, -C(=O)NR⁷R⁸ substituiert sein können,
ein verbrückender Rest der chemischen Struktur -A¹-X-A²-;
wobei R³, R⁴, R⁵, R⁶, R⁷, R⁸ unabhängig voneinander jeweils ausgewählt aus der Gruppe bestehend aus Wasserstoff, verzweigter oder unverzweigter Alkylrest mit 1 bis 10 Kohlenstoffatome sind;
wobei A¹, A² unabhängig voneinander jeweils eine verzweigte oder unverzweigte Alkylengruppe mit 1 bis 10 Kohlenstoffatomen ist;
und wobei X ausgewählt aus der Gruppe bestehend aus -O-, -S-S-, -S-, -NR⁹- mit R⁹ = Alkylrest mit 1 bis 10 Kohlenstoffatomen ist;
(c) Einarbeiten der Verbindung der chemischen Struktur **(II)** in das Polyolefincopolymer **(I).**

12. Verfahren nach Anspruch 11, wobei R¹ = R² = Wasserstoff und A = -CH₂-.

13. Verfahren nach Anspruch 11 oder 12, wobei das Polyolefincopolymer **(I)** ein Ethylen-Vinylacetat-Copolymer ist.

14. Verfahren nach einem der Ansprüche 11 bis 13, wobei mindestens 50 % aller von der pulverförmigen Verbindung der chemischen Struktur **(II)** umfassten Partikel eine Partikelgröße von ≤ 500 µm haben, bestimmt nach DIN/ISO 13320.

15. Dispersion **(D),** erhältlich nach dem Verfahren gemäß einem der Ansprüche 11 bis 14.

16. Verwendung einer Dispersion **(D)** nach Anspruch 15 zur Herstellung einer Folie zur Verkapselung einer elektronischen Vorrichtung.

17. Verfahren zur Herstellung einer Folie zur Verkapselung einer elektronischen Vorrichtung umfassend
(a) Vermischen der Dispersion **(D)** nach Anspruch 15 mit weiterem Polyolefincopolymer **(I)** zu einer Mischung;
(b) Extrudieren der in Schritt (a) erhaltenen Mischung zu einer Folie.

18. Verfahren nach Anspruch 17, wobei in Schritt (a) weitere Additive ausgewählt aus der Gruppe bestehend aus Initiatoren, weiteren Vernetzern, Silankupplungsmitteln, Antioxidantien, Alterungsschutzmittel, Metalloxiden, Metallhydroxiden, Weißpigmenten zugegeben werden.
